(19)

**Europäisches Patentamt**
**European Patent Office**
**Office européen des brevets**

(11)  **EP 4 354 416 A1**

(12)  # EUROPEAN PATENT APPLICATION
published in accordance with Art. 153(4) EPC

(43) Date of publication:
**17.04.2024  Bulletin 2024/16**

(21) Application number: **22820121.6**

(22) Date of filing: **01.06.2022**

(51) International Patent Classification (IPC):
**G09F 13/12** *(2006.01)*     **G09F 13/04** *(2006.01)*

(52) Cooperative Patent Classification (CPC):
**G09F 13/04; G09F 13/12**

(86) International application number:
**PCT/JP2022/022329**

(87) International publication number:
**WO 2022/259939 (15.12.2022 Gazette 2022/50)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.06.2021  JP 2021096430**

(71) Applicant: **TOPPAN INC.**
**Tokyo 110-0016 (JP)**

(72) Inventors:
• **NISHIJIMA Katsunori**
  **Tokyo 110-0016 (JP)**
• **HARADA Takahiro**
  **Tokyo 110-0016 (JP)**

(74) Representative: **Hoffmann Eitle**
**Patent- und Rechtsanwälte PartmbB**
**Arabellastraße 30**
**81925 München (DE)**

(54)  **DISPLAY DEVICE, DECORATIVE SHEET, AND METHOD FOR PRODUCING DISPLAY DEVICE**

(57)     There is provided a display device configured to display a design, such as wood grain, harmonious with the surroundings when not in operation, in which a decrease in the brightness or the image quality of an image is suppressed. To this end, a display device (101) includes: a base material (1), a printed layer (2) formed on the front surface of the base material (1); a plurality of light emitting units (3) fixed to the front surface of the printed layer (2) and each containing an inorganic LED element, and a control unit (101b) configured to drive the plurality of light emitting units (3), in which a picture pattern harmonious with the surroundings where the display device (101) is installed is used as a picture pattern of the printed layer (2), and an observer is allowed to visually recognize the printed layer (2) when not in operation and allowed to visually recognize a luminous display image by light emission by the emitting units (3) when in operation. The all amounts of emitted light of the plurality of light emitting units (3) reaches the observer with almost no reduction, and therefore the decrease in the brightness of the image can be suppressed, and consequently the decrease in the image quality can be suppressed.

FIG. 2

EP 4 354 416 A1

**Description**

Technical Field

The present invention relates to a display device, a decorative sheet, and a method for producing the display device.

Background Art

In a display device with a sheet having light transmittance and a design property provided on the front surface of a light-emitting display body, when the light-emitting display body is operated to emit light, the light from the light-emitting display body transmits through the sheet, allowing letters, figures, symbols, and the like displayed on the light-emitting display body to be visually recognized. On the other hand, when the light-emitting display body is not operated, the light-emitting display body cannot be recognized because the sheet covers the light-emitting display body, and thus a design harmonious with the surroundings can be achieved (see, for example, PTLS 1, 2 below).

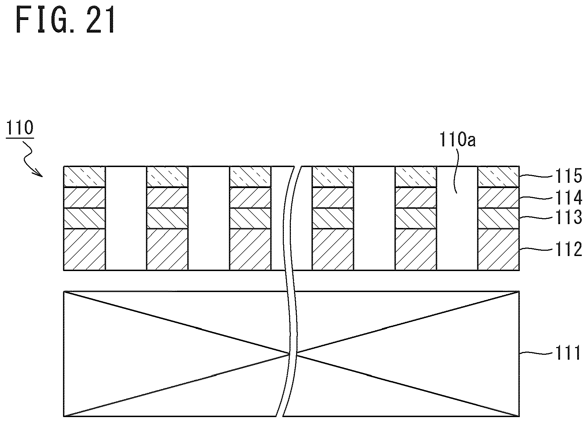

Such a display device includes a color adjustment layer 113, a design layer 114, and a surface protective layer 115 provided in this order on a sheet-like base material 112 containing resin or the like, in which a sheet formed with a large number of fine light-passing holes 110a formed by laser beam, a drill, or the like is provided on the front surface of a light-emitting display body 111 of a liquid crystal display or the like, for example, as illustrated in FIG. 21.

In the display device 110, when the light-emitting display body 111 is operated to emit light, the light passes through the light-passing holes 110a of the sheet, making the display of the light-emitting display body 111 recognizable. On the other hand, when the light-emitting display body 111 is not operated, the sheet covers the light-emitting display body 111, making the light-emitting display body 111 unrecognizable, and thus a design harmonious with the surroundings can be achieved.

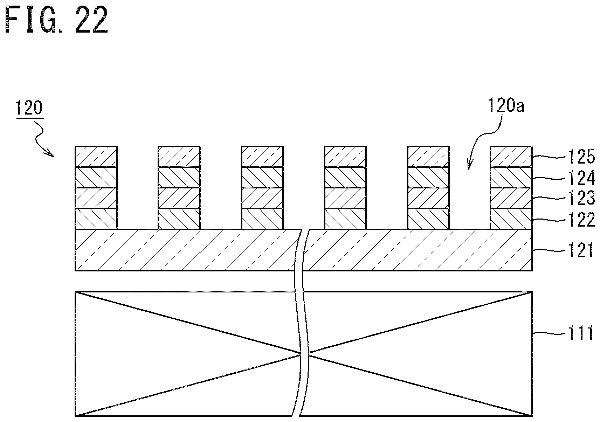

Further, there is a display device including, on the front surface of the light-emitting display body 111, a sheet provided by depositing a pattern layer 122, a color adjustment layer 123, a design layer 124, and a surface protective layer 125 in an array shape by a printing method to form a large number of fine cavities (holes) 120a allowing the passage of light on a sheet-like base material 121 containing resin or the like and having light transmittance as illustrated in FIG. 22, for example.

In the display device 120, when the light-emitting display body 111 is operated to emit light, the light passes through the cavities 120a of the sheet, making the display of the light-emitting display body 111 recognizable. On the other hand, when the light-emitting display body 111 is not operated, the sheet covers the light-emitting display body 111, making the light-emitting display body 111 unrecognizable, and thus a design harmonious with the surroundings can be obtained.

Citation List

Patent Literatures

PTL 1: JP 2018-128581 A
PTL 2: JP 6370519 B

Summary of Invention

Technical Problem

However, in the display devices 110 and 120 as described above, the sheet formed with the large number of light-passing holes 110a or the sheet formed on the sheet-like base material 121 having light transmittance such that the large number of fine cavities (holes) 120a allowing the passage of light are formed is provided on the front surface of the light-emitting display body 111. Therefore, light transmitting through the light-passing holes 110a or the cavities (holes) 120a of light emitted by the light-emitting display body 111 reaches an observer visually recognizing the display devices 110, 120. This reduces the amount of emitted light actually reaching the observer of the amount of emitted light by the light-emitting display body 111, posing a possibility of a decrease in the brightness or the image quality of an image visually recognized by the observer.

Thus, this invention has been made focusing on the conventional unsolved problems. It is an object of the present invention to provide a display device configured to display the display contents by the display device when the display device is operated and to display a predetermined image, such as wood grain, when the display device is not operated, in which the decrease in the brightness or the image quality of an image can be suppressed, a decorative sheet, and a method for producing the display device.

Solution to Problem

One aspect of the present invention provides a display device including: a base material; a picture pattern layer formed on the front surface of the base material; a plurality of light emitting units fixed to the front surface of the picture pattern layer and each containing an inorganic LED element; and a control unit configured to drive the plurality of light emitting units.

Another aspect of the present invention provides a display device including: a base material having light transmittance; a picture pattern layer formed on the back surface of the base material; a plurality of light emitting units formed on the front surface of the base material and each containing an inorganic LED element; and a control unit configured to drive the plurality of light emitting units.

Another aspect of the present invention provides a display device including: a colored sheet; a plurality of light emitting units fixed to the front surface of the colored sheet and each containing an inorganic LED element; a surface protective layer provided to cover the plurality of light emitting units and the surface to which the plurality of light emitting units is fixed and having light transmittance; a pattern forming layer provided on the surface on the side facing the light emitting units of the surface protective layer and configured to impart a pattern to light from the plurality of light emitting units and transmit the light; and a control unit configured to drive the light emitting units.

Further, another aspect of the present invention provides a decorative sheet including the display device of any one of the above-described aspects, in which the display device is provided on a part of the front surface of the decorative sheet.

Further, another aspect of the present invention provides a method for producing a display device, the display device being the display device according to any one of the above-described aspects, including: forming the circuit wiring lines on the front surface of the base material; forming an ink layer lowering the visibility of the installation surface of the display device, the base material, and the circuit wiring lines on the front surface of the base material including the circuit wiring lines; and, after forming the ink layer, installing the light emitting units on the front surface of the base material.

Advantageous Effects of Invention

One aspect of the present invention can suppress the decrease in the brightness or the decrease in the image quality of a predetermined luminous image, such as wood grain, of the display device configured to display the display contents by the display device when the display device is operated and to display the luminous image when the display device is not operated.

Brief Description of Drawings

FIG. 1 is a schematic configuration diagram illustrating one example of a display device according to one embodiment of the present invention;
FIG. 2 is a cross-sectional view illustrating the schematic configuration of one example of a display unit according to a first embodiment;
FIG. 3 is a cross-sectional view illustrating the schematic configuration of a modification of the display unit according to the first embodiment;
FIG. 4 is a cross-sectional view illustrating the schematic configuration of one example of a display unit according to a second embodiment;
FIG. 5 is a cross-sectional view illustrating the schematic configuration of a modification of the display unit according to the second embodiment;
FIG. 6 is a cross-sectional view illustrating the schematic configuration of one example of a display unit according to a third embodiment;
FIG. 7 is a cross-sectional view illustrating the schematic configuration of a modification of the display unit according to the third embodiment;
FIG. 8 is a cross-sectional view illustrating the schematic configuration of a modification of the display unit according to the third embodiment;
FIG. 9 is a cross-sectional view of the display unit of FIG. 8 as viewed from a direction in which a circuit wiring line extends;

FIG. 10 is a cross-sectional view illustrating the schematic configuration of a modification of the display unit according to the third embodiment;

FIG. 11 is a cross-sectional view of the display unit of FIG. 10 as viewed from a direction in which a circuit wiring line extends;

FIGS. 12A to 12C are explanatory views for explaining the modification of the display unit according to the third embodiment;

FIG. 13 is a cross-sectional view illustrating the schematic configuration of a modification of the display unit according to the third embodiment;

FIG. 14 is a cross-sectional view of the display unit of FIG. 13 as viewed from a direction in which a circuit wiring line extends;

FIG. 15 is a cross-sectional view illustrating the schematic configuration of one example of a display unit according to a fourth embodiment;

FIG. 16 is a cross-sectional view illustrating the schematic configuration of a modification of the display unit according to the fourth embodiment;

FIG. 17 is a cross-sectional view illustrating the schematic configuration of one example of a display unit according to a fifth embodiment;

FIG. 18 is a cross-sectional view illustrating the schematic configuration of a modification of the display unit according to the fifth embodiment;

FIG. 19 is an explanatory view illustrating one example of a display unit according to a seventh embodiment;

FIGS. 20A to 20D are explanatory views for explaining circuit wiring according to an eighth embodiment;

FIG. 21 is a cross-sectional view illustrating the schematic configuration of one example of a conventional display device; and

FIG. 22 is a cross-sectional view illustrating the schematic configuration of one example of a conventional display device.

Description of Embodiments

Embodiments of the present disclosure will now be described with reference to the drawings. In the following description of the drawings, the same or similar reference numerals are attached to the same or similar parts. The drawings are schematic, and the relationship between the thickness and the plane dimension, the thickness ratio of each layer, and the like are different from the actual relationship, ratio, and the like. The drawings include portions different in mutual dimensional relationships and ratios.

The embodiments described below exemplify devices or methods for embodying the technical idea of the present disclosure. In the technical idea of the present disclosure, the arrangement and the like of constituent components are not limited to the arrangement and the like described below. The technical idea of the present disclosure can be added with various alternations within the technical range defined by Claims.

[First embodiment]

First, a display device 101 according to a first embodiment of the present invention is described.

(Configuration)

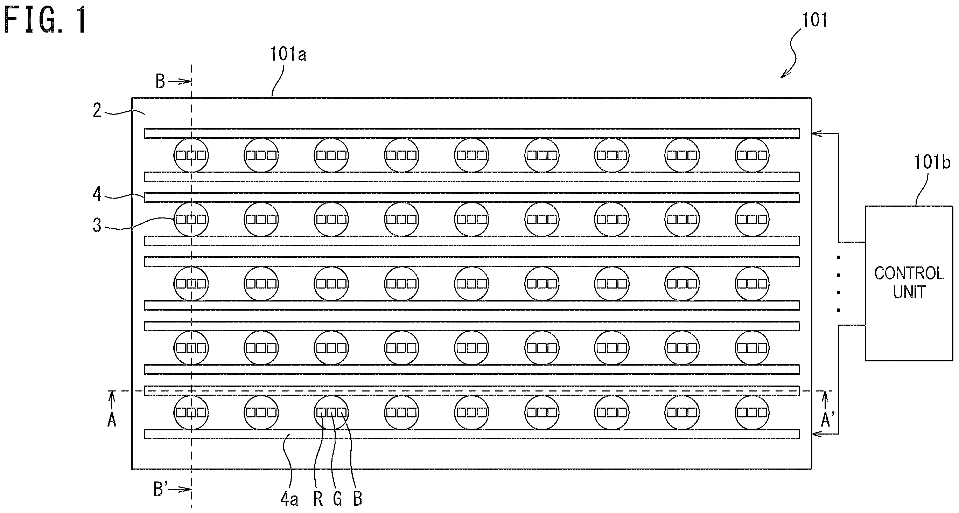

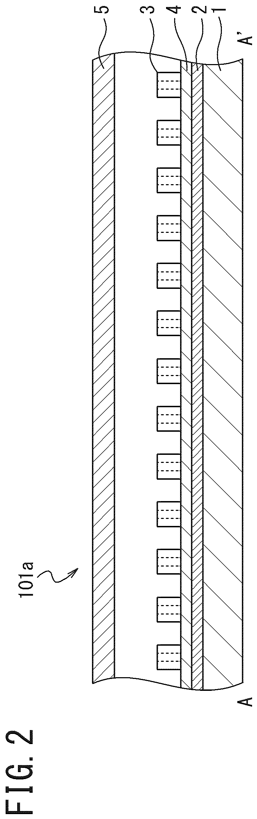

FIG. 1 is a schematic configuration diagram illustrating one example of the display device 101 according to the first embodiment. FIG. 2 is a part of a cross-sectional view in the A-A' cross section of a display unit 101a described later illustrated in FIG. 1. For ease of understanding, FIG. 1 does not illustrate a surface protective layer 5 described later. For ease of understanding, FIG. 2 does not correspond to FIG. 1 in terms of the number of the light emitting units 3 described later.

The display device 101 includes the display unit 101a and a control unit 101b driving and controlling the display unit 101a.

The display unit 101a includes a sheet-like base material 1, a printed layer (picture pattern layer) 2 printed on the front surface of the base material 1, a plurality of light emitting units 3 fixed to the front surface of the printed layer 2, circuit wiring lines 4 configured to drive the light emitting units 3 fixed to the front surface of the printed layer 2, and a surface protective layer 5 provided to cover the printed layer 2, the light emitting units 3, and the circuit wiring lines 4 as illustrated in FIG. 2.

The base material 1 is formed of a resin film, for example. The base material 1 is not limited to the resin film, and any member is applicable. For example, when a relatively lightweight member, such as film, is used as the base material 1, the whole display device 101 can be reduced in weight, and therefore the display device 101 having a relatively large screen can be realized. Further, the arrangement position of the display device 101 is less restricted by the weight of the whole display device 101, increasing the versatility. The base material 1 may have a rectangular shape as illustrated in FIG. 1 or may have any other shape.

The printed layer 2 is formed by printing and applying various types of designs, such as wood grain vessel or marble, with ink. The design of the printed layer 2 is designed to harmonize with a place where the display device 101 is installed. Due to such a design, the display device 101 is harmonized with the surroundings when the light emitting units 3 do not emit light. The printed layer 2 is not limited to one formed by printing and applying, and may be formed by any method insofar as a design harmonious with the surroundings can be formed.

The light emitting unit 3 contains, for example, a 3-in-1 chip surface-mounted LED element with three LED elements corresponding to RGB combined into one. The light emitting units 3 are arranged in alignment in the row and column directions, i.e., in a matrix shape.

As the LED element constituting the light emitting unit 3, an inorganic LED, such as a micro-LED, is applicable. The light emitting unit 3 is not limited to the 3-in-1 chip element, and may include an LED element for each of RGB. Any inorganic LED element is applicable without being limited to the surface mount LED element. The size or the shape of the inorganic LED element constituting the light emitting unit 3 may be set according to the installation position of the display unit 101a, the distance between an observer visually recognizing the display contents of the display unit 101a and the display unit 101a, the size of the display unit 101a, or the image quality or the brightness of a luminous image required in the display device 101, for example. The light emitting unit 3 does not have to be a color one and may be a monochromatic one.

In FIG. 1, the light emitting units 3 are arranged in alignment in the row and column directions on the entire front surface of the base material 1, but the light emitting units 3 may be provided only in places required when letters and the like are displayed by light emission. To achieve versatility and to prevent colors of the display unit 101a visually recognized by an observer from varying depending on the presence or absence of the light emitting units 3, for example, it may be acceptable that the light emitting units 3 are arranged in alignment on the entire front surface of the base material 1, and only the light emitting units 3 required for displaying letters and the like by light emission are connected to the circuit wiring lines 4, while the other light emitting units 3 may be arranged as dummies without being connected to the circuit wiring lines 4.

The circuit wiring line 4 is arranged on each side of the light emitting units 3 arranged in alignment in the row direction as illustrated in FIG. 1, and the circuit wiring line 4 for each of the inorganic LED elements contained in the light emitting units 3 and feeding a signal or power to the inorganic LED element is connected to the control unit 101b, and the inorganic LED element contained in each of the light emitting units 3 is driven and controlled by the control unit 101b. The driving method of the inorganic LED elements is not limited thereto, and any method commonly used as a system for drying an LED display is also applicable, for example. The arrangement positions of the circuit wiring lines 4 are not limited to the arrangement positions illustrated in FIG. 1, and the circuit wiring lines 4 can be arranged at any position.

The surface protective layer 5 is formed of a colorless or colored transparent resin or the like, for example, has light transmittance, and protects the light emitting units 3 and the printed layer 2. The surface protective layer 5 may have a sheet shape, or a coating film may be formed by printing and applying resin on the entire region containing the light emitting units 3 and the printed layer 2. The surface protective layer 5 may also include a coating layer for gloss adjustment or the like on the front surface.

The surface protective layer 5 may be provided on the light-emitting surface side of the light emitting units 3 with a gap between the light emitting units 3 and the surface protective layer 5 to dissipate heat of the light emitting units 3 as illustrated in FIG. 2 or the surface protective layer 5 may be arranged on the light emitting units 3 with gaps between the light emitting units 3 filled with a filler or the like.

[Production method]

Next, a method for producing the display device 101 is described.

First, ink is printed and applied to the front surface of the base material 1 to form the printed layer 2. Next, the light emitting units 3 and the circuit wiring lines 4 are fixed onto the top of the printed layer 2 for electrical connection. A method for fixing and connecting the light emitting units 3 and the circuit wiring line 4 is not particularly limited. For example, the circuit wiring lines are printed in a pattern shape using a conductive ink containing metal, such as silver or copper, and the light emitting units 3 are electrically connected and fixed to predetermined positions by a method, such as thermocompression bonding, using a conductive material, such as solder.

Next, the surface protective layer 5 is provided by printing and applying a colorless or colored transparent ink to the entire front surface of the base material 1 or depositing a colorless or colored transparent resin or the like on the entire front surface of the base material 1 to cover the light emitting units 3, the circuit wiring lines 4, and the printed layer 2. Thus, the display unit 101a is formed. Then, the circuit wiring lines 4 and the control unit 101b are electrically connected to each other, whereby the display device 101 can be produced.

[Action]

Next, the action of the display device 101 is described.

When an observer visually observes the surface where the light emitting units 3 are arranged of the display unit 101a (hereinafter also referred to as a light-emitting display surface), driving the light emitting units 3 by the control unit 101b to emit light allows the observer to visually recognize the luminous image, such as letters or figures, displayed by light emission through the surface protective layer 5. At this time, the light emitting units 3, the printed layer 2, and the circuit wiring lines 4 are included within the field of view of the observer through the surface protective layer 5, but the observer more easily visually recognizes the luminous image by the light emitting units 3 than the printed layer 2 not emitting light and is difficult to recognize the printed layer 2 by emitted light from the light emitting units 3. Therefore, the luminous image displayed by the light emitting units 3 is more easily visually recognized by the observer, so that the observer can recognize the luminous image. In particular, all the light emitted by all the light emitting units 3 passes through only the surface protective layer 5 and reaches the observer. Therefore, the amount of emitted light reaching the observer of the amount of emitted light by the light emitting units 3 almost corresponds to the reduction amount when the light transmits through the surface protective layer 5, and the other emitted light reaches the observer. Therefore, the observer can visually recognize the luminous image by the light emitting units 3 with the brightness reduced corresponding to the reduction amount when the light passes through the surface protective layer 5, and visually recognize the luminous image with a relatively bright and good image quality. Thus, from also the point that the brightness of the luminous image visually recognized by the observer hardly decreases, the printed layer 2 can be conversely made difficult to be visually recognized, and thus the luminous image can be visually recognized with better image quality.

On the other hand, when the light emission of the light emitting units 3 is stopped by the control unit 101b, the light emitting units 3, the printed layer 2, and the circuit wiring lines 4 are included, through the surface protective layer 5, within the field of view of the observer visually observing the light-emitting display surface. However, the light emitting units 3 or the circuit wiring lines 4 not emitting light appear to the observer as projection parts arranged in alignment and linear meaningless objects, respectively, or are hardly visually recognized by the observer depending on the size of the light emitting units 3 or the distance from the observer. Conversely, the printed layer 2 appears as a design to the observer due to various designs, such as wood grain vessel or marble. Therefore, the observer more easily visually recognizes the printed layer 2 than the light emitting units 3, the circuit wiring line 4, and the like, so that the display unit 101a becomes a design harmonious with the surroundings of the display unit 101a.

[Effects]

(1) By the configuration in which the light emitting units 3 are arranged on the printed layer 2, and the light emitting units 3 and the printed layer 2 are covered by the surface protective layer 5, the amount of emitted light decreasing before reaching an observer of the amount of emitted light of the light emitting units 3 can be suppressed to about the reduction amount due to the transmission through the surface protective layer 5, allowing the observer to visually recognize the luminous image with a relatively bright and good image quality.

(2) The display device 101 can be realized by providing the printed layer 2 on the front surface of the sheet-like base material 1 and fixing the light emitting units 3 and the circuit wiring lines 4 to the front surface of the printed layer 2, and therefore the decrease in weight of the whole display device 101 can be achieved. Therefore, even the display device 101 with a relatively large screen, such as a large screen, for example, can be easily realized.

(3) The display unit 101a can be configured to have a relatively small thickness and is lightweight, and therefore the display device 101 can be easily installed, and can be installed in the manner of bonding wallpaper. Further, the display unit 101a is relatively deformable, and therefore the display unit 101a can be easily arranged on a non-flat place, such as a curved surface. The ease of handling allows easy installation of the display unit 101a of any size from the display unit 101a with a relatively large screen, such as a large screen, to the display unit 101a with a relatively small screen, such as a vehicle interior panel or table.

(4) The inorganic LED element is used as the light emitting unit 3, and the inorganic LED element is a point-light-emitting element and is usable with higher brightness and for a longer period of time than an organic EL. Therefore, both an improvement of the brightness and the durability of the luminous image when the luminous image is displayed can be achieved.

[Modification]

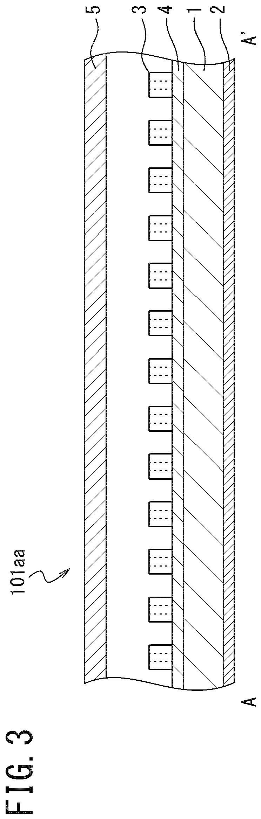

The display unit 101a includes the printed layer 2 on the front surface of the base material 1 as illustrated in FIG. 2. However, as illustrated in a display unit 101aa of FIG. 3, the printed layer 2 may be provided on the back surface of the base material 1, and the light emitting units 3 and the circuit wiring lines 4 may be fixed to the front surface of the base material 1. In this case, the base material 1 is preferably formed of a colorless or colored transparent member, and is constituted by a colorless or colored transparent resin film or the like, for example. FIG. 3 is a part of a cross-sectional view when the display unit 101aa is cut in the cross-section corresponding to the same part as that of FIG. 2.

The display unit 101a and the display unit 101aa include the surface protective layer 5. However, when the display device 101 is arranged in an environment, such as indoors, where the light emitting units 3 and the like are not required to be protected, for example, the surface protective layer 5 is not always have to be provided.

[Second embodiment]

Next, a display device according to a second embodiment of the present invention is described.

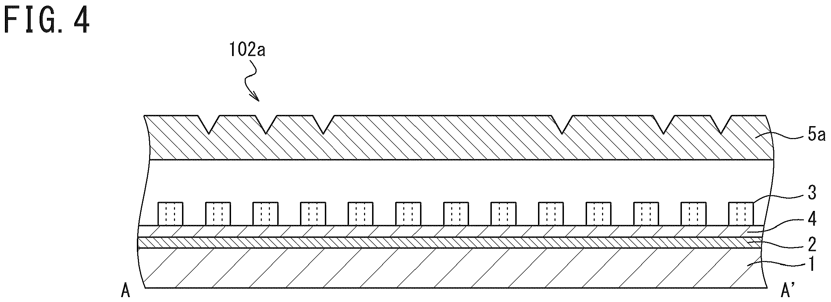

The display device according to this second embodiment is different in the configuration of the display unit 101a in the display device 101 according to the first embodiment as illustrated in FIG. 4. The same reference numerals are attached to the same parts as those of the display unit 101a, and detailed descriptions of the same parts are omitted. FIG. 4 is a part of a cross-sectional view when a display unit 102a described later is cut in the cross-section corresponding to the same part as that of FIG. 2.

More specifically, the display unit 102a of the display device according to the second embodiment includes the printed layer 2 printed on the front surface of the base material 1, the light emitting units 3 and the circuit wiring lines 4 fixed to the front surface of the printed layer 2, and a shaped sheet 5a to cover the printed layer 2, the light emitting units 3, and the circuit wiring lines 4 as with the display unit 101a according to the first embodiment. The shaped sheet 5a is formed of a colorless or colored transparent resin or the like and has light transmittance. The surface facing the light emitting units 3 of the shaped sheet 5a is formed with a plurality of recessed portions. Herein, the shaped sheet 5a is formed with the recessed portions, but may be formed with projection portions or may be formed with recessed portions and projection portions.

Thus, the use of the shaped sheet 5a as the surface protective layer 5 makes it possible to impart a design property, such as an irregular shape, to the light-emitting display surface of the display unit 102a, and can further harmonize the display unit 102a when the light emitting unit 3 are not caused to emit light with the surroundings.

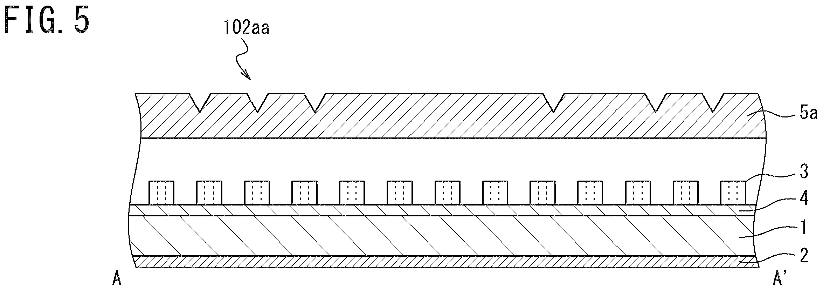

Although the display unit 102a includes the printed layer 2 provided on the front surface of the base material 1 as illustrated in FIG. 4, it may be acceptable that the printed layer 2 is provided on the back surface of the base material 1, and the light emitting units 3 and the circuit wiring lines 4 are fixed to the front surface of the base material 1 as illustrated in a display unit 102aa of FIG. 5. In this case, the base material 1 is preferably formed of a colorless or colored transparent member, and, for example, constituted by a colorless or colored transparent resin film or the like. FIG. 5 is a part of a cross-sectional view when the display unit 102aa is cut in the cross-section corresponding to the same part as that of FIG. 2.

[Third embodiment]

Next, a display device according to a third embodiment of the present invention is described.

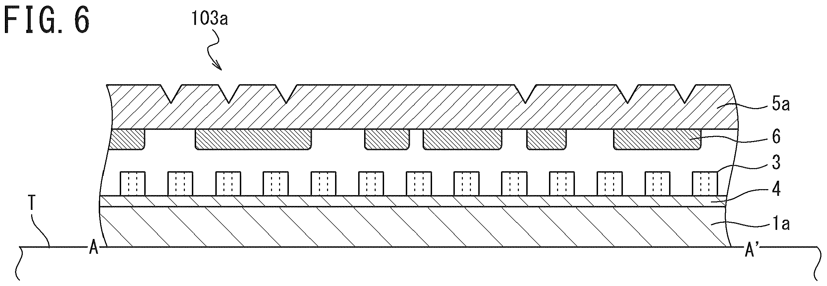

The display device according to this third embodiment is different in the configuration of the display unit 101a in the display device 101 according to the first embodiment as illustrated in FIG. 6. The same reference numerals are attached to the same parts as those of the display unit 101a, and detailed descriptions of the same parts are omitted. FIG. 6 is a part of a cross-sectional view when a display unit 103a described later is cut in the cross-section corresponding to the same part as that of FIG. 2.

The display unit 103a of the display device according to the third embodiment uses a colored sheet 1a in place of the base material 1, and the light emitting units 3 and the circuit wiring lines 4 are fixed to the front surface of the colored sheet 1a. Further, a picture pattern printed layer 6 is printed on the surface opposite to the surface on which the shape is formed of the shaped sheet 5a used in FIG. 4, the picture pattern printed layer 6 and the light emitting unit 3 are made to face each other, and the shaped sheet 5a is arranged to cover the light emitting units 3, the circuit wiring lines 4, and the colored sheet 1a. The shaped sheet 5a may be arranged such that the picture pattern printed layer 6 and the light emitting units 3 are in contact with each other or may be arranged such that the picture pattern printed layer 6 and the light emitting units 3 form a gap.

The colored sheet 1a preferably has a color, such as white or silver, complementing the color tone of a picture pattern design of the picture pattern printed layer 6. More specifically, even when the light emitting units 3 are not caused to emit light, so that an observer recognizes the color of the colored sheet 1a overlapping with the picture pattern of the picture pattern printed layer 6, the observer can be inhibited from recognizing the color as a dull color, a decrease in the degree of harmony with the surroundings given to the observer can be suppressed, and a sense of design adapted to the surrounding environment can be given to the observer. The colored sheet 1a is constituted by a sheet containing a resin mixed with pigments, for example.

The picture pattern printed layer 6 is formed by printing and applying various designs, such as wood grain vessel or marble, with ink to have light transmittance, and the picture pattern is formed with a light transmitting ink, a pattern in which regions where no ink is printed and applied are left (hereinafter referred to as a transmitting pattern), or a combination thereof.

Thus, the picture pattern formed with a light transmitting ink, the pattern including the regions where no ink is printed and applied, or a combination thereof is provided on the surface facing the light emitting units 3 of the shaped sheet 5a, whereby, when the light emitting units 3 are caused to emit light, the emitted light from the light emitting units 3 passes through the shaped sheet 5a. Although the light emitting units 3, the picture pattern printed layer 6, the circuit wiring lines 4, and the colored sheet 1a are included, through the shaped sheet 5a, within the field of view of an observer visually recognizing the light-emitting display surface, the observer more easily recognizes the emitted light from the light emitting units 3, and therefore can recognize the luminous image formed by the emitted light from the light emitting units 3. At this time, in the case of the display unit 103a according to the third embodiment, the emitted light from the light emitting units 3 transmits through the shaped sheet 5a passing through the light transmitting ink or the regions where no ink is applied, and therefore only a part of all amounts of emitted light of all of the light emitting units 3 reaches the observer. A comparison between a conventional method for providing the transmitting pattern on the display surface side of the light-emitting display body and the display unit 103a including the light transmitting ink, the transmitting pattern including the regions where no ink is printed and applied, or a combination thereof (picture pattern printed layer 6) on the light-emitting surface side of the light emitting units 3, the light transmittance is higher in the display unit 103a. Therefore, the amount of emitted light reaching the observer is larger in the display unit 103a than in the case of using the conventional light-emitting display body.

Therefore, the passage of a part of the emitted light is inhibited by the picture pattern printed layer 6, but the amount of emitted light reaching the observer can be increased as compared with that of a conventional one, and thus an improvement of the brightness and an improvement of the image quality of the luminous image can be achieved.

On the other hand, when the light emitting units 3 are not caused to emit light, the light emitting units 3, the picture pattern printed layer 6, the circuit wiring lines 4, and the colored sheet 1a are included, through the shaped sheet 5a, within the field of view of the observer visually recognizing the light-emitting display surface. However, the light emitting units 3 or the circuit wiring lines 4 appear as meaningless objects to the observer or cannot be visually recognized depending on the size or the like of places where no ink is applied of the picture pattern printed layer 6, and thus are consequently visually recognized as a design containing the colored sheet 1a and the picture pattern printed layer 6 and harmonious with the surroundings of the display unit 103a.

Thus, the display unit 103a according to the third embodiment has the amount of emitted light reaching the observer smaller than that of a case where the picture pattern printed layer is not provided on the light-emitting surface side of the light emitting units 3 as in the display units 101a, 102a according to the first and second embodiments, respectively. However, an improvement of the brightness and an improvement of the image quality of the luminous image can be achieved as compared with a conventional case where the picture pattern printed layer is provided on the surface of the light-emitting display body and, further, it appears to the observer as a design represented by the picture pattern printed layer 6 and the colored sheet 1a, and therefore a wide range of design variations can be achieved.

Although the case of covering the light emitting units 3 and the like with the shaped sheet 5a is described above, the surface protective layer 5 according to the first embodiment is usable in place of the shaped sheet 5a.

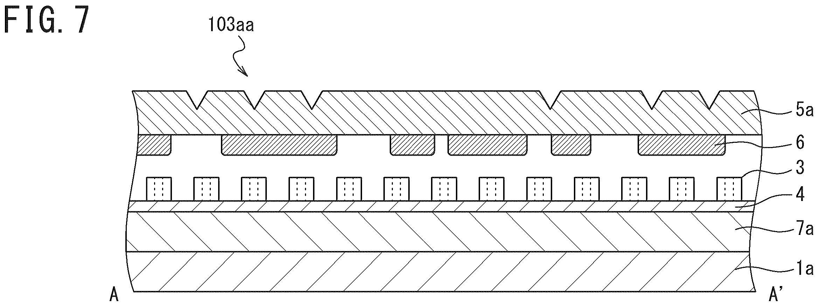

In the display unit 103a, the light emitting units 3 and the circuit wiring lines 4 are fixed to the front surface of the colored sheet 1a as illustrated in FIG. 6. However, as illustrated in a display unit 103aa of FIG. 7, it may be acceptable that a transparent sheet 7a is provided on the front surface of the colored sheet 1a, and the light emitting units 3 and the circuit wiring lines 4 are fixed to the front surface of the transparent sheet 7a. Thus, the color tone of the colored sheet 1a can be easily changed or corrected. The transparent sheet 7a is constituted by a colorless or colored transparent resin having light transmittance or the like, for example. FIG. 7 is a part of a cross-sectional view when the display unit 103aa is cut in the cross-section corresponding to the same part as that of FIG. 2.

In the display unit 103a according to the third embodiment, the colored sheet 1a may have the following configurations.

[Modification 1 of colored sheet 1a]

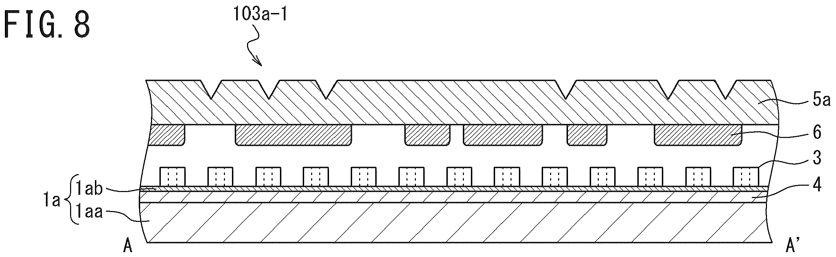

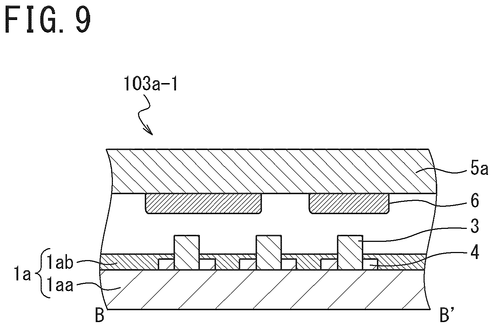

The colored sheet 1a may be formed of a base material having an ink layer 1ab obtained by applying ink to the front surface of a base material 1aa containing a substrate, a sheet-like member, or the like, for example, as illustrated in FIGS. 8 and 9. FIG. 8 is a part of a cross-sectional view when a display unit 103a-1 in which the colored sheet 1a contains the base material 1aa and the ink layer 1ab is cut in the cross-section corresponding to the same part as that of FIG. 2. FIG. 9 is a part of a cross-sectional view when the display unit 103a-1 is cut in the cross-section corresponding to the same part as that of the B-B' cross section of the display unit 101a illustrated in FIG. 1.

In this case, the circuit wiring lines 4 are formed on the front surface of the base material 1aa, and thereafter ink is applied to the entire front surface of the base material 1aa containing the circuit wiring lines 4 to provide the ink layer 1ab. Thereafter, the light emitting units 3 are fixed to the base material 1aa formed with the ink layer 1ab.

The color of the ink layer 1ab is preferably a color, such as white or silver, making it difficult for an observer to visually recognize the installation surface of the display unit 103a-1, or the base material 1aa and the circuit wiring lines 4 when the observer looks at the display unit 103a-1.

Thus, by providing the ink layer 1ab to cover the base material 1aa and the circuit wiring lines 4, an observer can be inhibited from visually recognizing the installation surface 4 of the display unit 103a-1, or the base material 1aa and the circuit wiring lines 4, and restrictions on the color of members applicable as the installation surface of the display unit 103a-1, or the base material 1aa or the circuit wiring lines 4 can be reduced, widening the range of members applicable as the installation surface of the display unit 103a-1, the base material 1aa, or the circuit wiring lines 4.

[Modification 2 of colored sheet 1a]

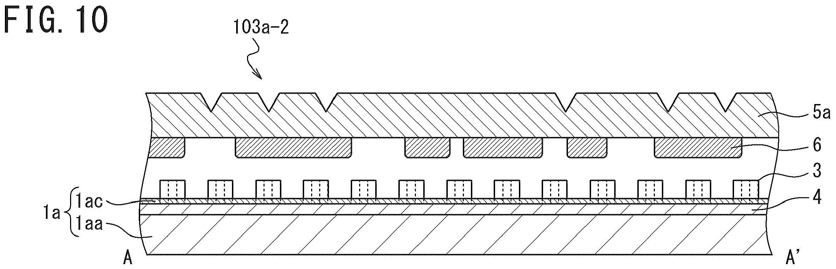

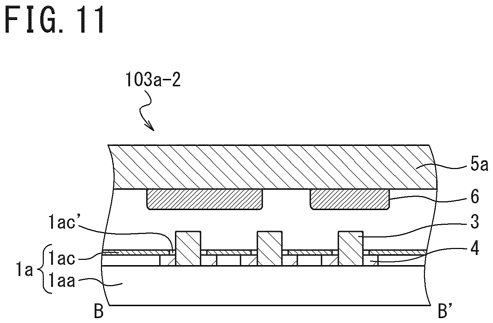

The colored sheet 1a may be formed by the base material 1aa containing a substrate, a sheet-like member, or the like, and a concealing sheet 1ac formed to cover a region excluding the light emitting units 3, for example, as illustrated in FIGS. 10 and 11. FIG. 10 is a part of a cross-sectional view when a display unit 103a-2 in which the colored sheet 1a contains the base material 1aa and the concealing sheet 1ac is cut in the cross-section corresponding to the same part as that of FIG. 2. FIG. 11 is a part of a cross-sectional view when the display unit 103a-2 is cut in the cross-section corresponding to the same part as that of the B-B' cross section of the display unit 101a illustrated in FIG. 1.

As illustrated in FIGS. 10 and 11, the concealing sheet 1ac has a size sufficient to cover the entire front surface of the base material 1aa and is formed with through holes 1ac' almost equal to the light emitting units 3 in plan view at positions facing the light emitting units 3 and allowing the passage of the light emitting units 3. Then, the concealing sheet 1ac is placed over the base material 1aa with each light emitting unit 3 passing through each through hole 1ac' in a state where the circuit wiring lines 4 and the light emitting units 3 are fixed to the front surface of the base material 1aa, so that each part excluding the light emitting units 3 on the base material 1aa in plan view is covered by the concealing sheet 1ac. At least the surface opposite to the base material 1aa of the concealing sheet 1ac preferably has a color, such as white or silver, making it difficult for an observer to visually recognize the installation surface of the display unit 103a-2, or the base material 1aa and the circuit wiring lines 4 when the observer looks at the display unit 103a-2. By providing the concealing sheet 1ac to cover the entire front surface of the base material 1aa excluding the light emitting units 3, an observer can be inhibited from visually recognizing the installation surface 4 of the display unit 103a-2, or the base material 1aa, the circuit wiring lines 4, and restrictions on the color of members applicable as the installation surface of the display unit 103a-2, the base material 1aa, or the circuit wiring lines 4 can be reduced, widening the range of members applicable as the installation surface of the display unit 103a-2, the base material 1aa, or the circuit wiring line 4 also in this case.

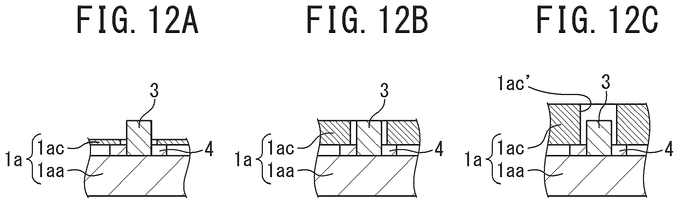

At this time, as illustrated in FIGS. 12A to 12C, the upper end of the concealing sheet 1ac may be lower than the upper end of the light emitting unit 3 (FIG. 12A), the upper end of the concealing sheet 1ac may be conversely higher than the upper end of the light emitting unit 3 (FIG. 12C), or the concealing sheet 1ac may have such a thickness that the upper end of the concealing sheet 1ac and the upper end of the light emitting unit 3 are flush with each other (FIG. 12B) in side view.

When the upper end of the concealing sheet 1ac is higher than the upper end of the light emitting units 3, the concealing sheet 1ac limits the emitted light by the light emitting units 3, and therefore the emitted light can be formed with directivity. For example, when an observer looks at the display unit 103a from a position oblique to the position facing the light-emitting surface of the light emitting units 3, the luminous image can be made less visible. Conversely, when the upper end of the concealing sheet 1ac is lower than the upper end of the light emitting units 3, the emitted light by the light emitting units 3 is not limited by the concealing sheet 1ac, and therefore the luminous image of the display unit 103a can be made visible from a wider range. When the upper end of the concealing sheet 1ac and the upper end of the light emitting units 3 are flush with each other, the concealing sheet 1ac can protect the light emitting units 3 from any impact from the outside by any cause.

[Modification 3 of colored sheet 1a]

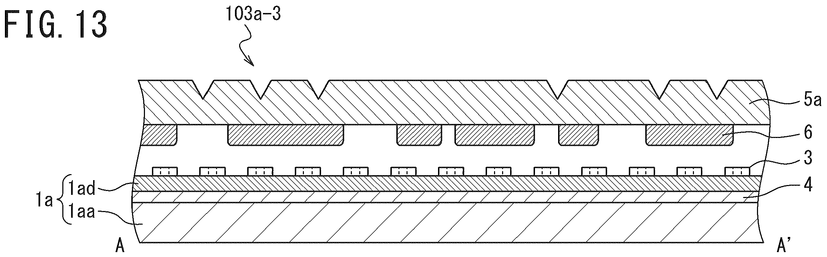

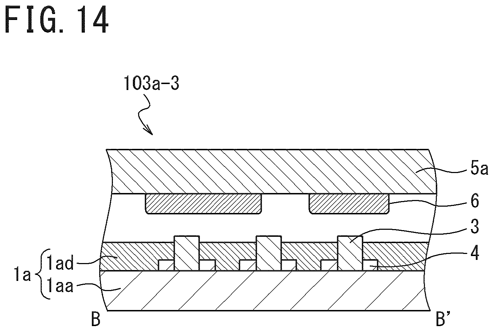

The colored sheet 1a may be formed by the base material 1aa containing a substrate, a sheet-like member, or the like, and a resin layer 1ad formed on the base material 1aa to fill gaps between the light emitting units 3, for example, as illustrated in FIGS. 13 and 14. FIG. 13 is a part of a cross-sectional view when a display unit 103a-3 in which the colored sheet 1a contains the base material 1aa and the resin layer 1ad is cut in the cross-section corresponding to the same part as that of FIG. 2. FIG. 14 is a part of a cross-sectional view when the display unit 103a-3 is cut in the cross-section corresponding to the same part as that of the B-B' cross section of the display unit 101a illustrated in FIG. 1.

In this case, the circuit wiring lines 4 are formed on the front surface of the base material 1aa, and thereafter the resin layer 1ad is formed on the entire front surface of the base material 1aa containing the circuit wiring lines 4 to fill the gaps between the light emitting units 3. The resin layer 1ad preferably has a color, such as white or silver, making it difficult for an observer to visually recognize the installation surface of the display unit 103a-3, the base material 1aa, or the circuit wiring lines 4 when the observer looks at the display unit 103a-3.

Thus, by forming the resin layer 1ad to cover the base material 1aa and the circuit wiring lines 4, it can be made difficult for an observer to visually recognize the installation surface 4 of the display unit 103a-3, and restrictions on the color of members applicable as the installation surface of the display unit 103a-3, or the base material 1aa or the circuit wiring lines 4 can be reduced, widening the range of members applicable as the base material 1aa or the circuit wiring line 4 also in this case.

Also in this case, it may be acceptable that the thickness of the resin layer 1ad is adjusted such that the upper end of the resin layer 1ad and the upper end of the light emitting unit 3 are flush with each other or the upper end of the light emitting unit 3 is made lower or higher than the upper end of the resin layer 1ad as with the case of Modification 2, thereby imparting directivity or protection.

[Fourth embodiment]

Next, a display device according to a fourth embodiment of the present invention is described.

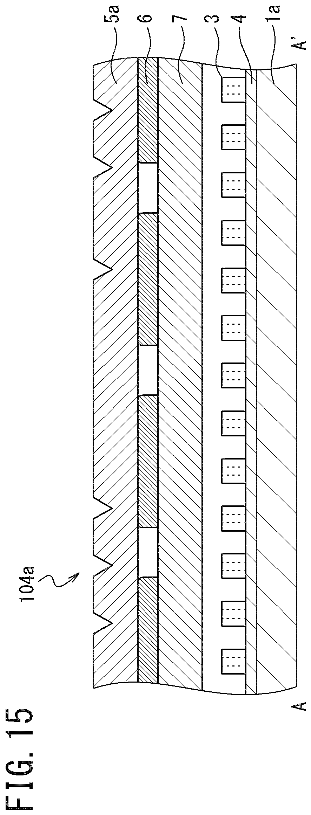

The display device according to this fourth embodiment is different in the configuration of the display unit 103a in the display device according to the third embodiment as illustrated in FIG. 15. The same reference numerals are attached to the same parts as those of the display unit 103a, and detailed descriptions of the same parts are omitted. FIG. 15 is a part of a cross-sectional view when a display unit 104a is cut in the cross-section corresponding to the same part as that of FIG. 2.

The display unit 104a of the display device according to the fourth embodiment is obtained by providing a transparent sheet 7 to protect the light emitting units 3 and the circuit wiring lines 4 fixed to the front surface of the colored sheet 1a, and depositing the picture pattern printed layer 6 formed by printing and applying ink, for example, and the shaped sheet 5a containing a transparent sheet protecting the picture pattern printed layer 6 on the surface opposite to the light emitting units 3 of the transparent sheet 7 in the display unit 103a according to the third embodiment as illustrated in FIG. 15. The transparent sheet 7 is constituted by a colorless or colored transparent resin having light transmittance or the like, for example.

Also in this case, the amount of emitted light reaching an observer is smaller than that of a case where the picture pattern printed layer is not provided on the light-emitting surface side of the light emitting units 3 as in the display units 101a, 102a according to the first and second embodiments, respectively, as with the display unit 103a according to the third embodiment. However, an improvement of the brightness and an improvement of the image quality of the luminous image can be achieved as compared with a conventional one in which the picture pattern printed layer is provided on the surface of the light-emitting display body.

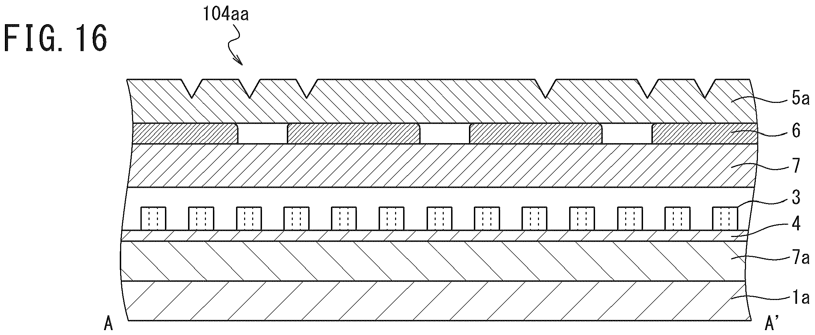

Also in this case, it may be acceptable that the transparent sheet 7a is provided on the front surface of the colored sheet 1a, and the light emitting units 3 and the circuit wiring lines 4 are fixed to the front surface of the transparent sheet 7a as illustrated in a display unit 104aa of FIG. 16 as with the display unit 103aa of FIG. 7. The colored sheets described in Modification 1 to Modification 3 of the colored sheet 1a are also applicable as the colored sheet 1a.

[Fifth embodiment]

Next, a display device according to a fifth embodiment of the present invention is described.

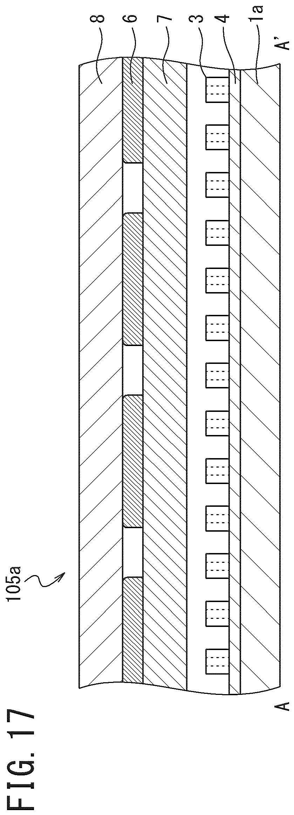

The display device according to this fifth embodiment is different in the configuration of the display unit 104a in the display device according to the fourth embodiment as illustrated in FIG. 17. The same reference numerals are attached to the same parts as those of the display unit 104a, and detailed descriptions of the same parts are omitted. FIG. 17 is a cross-sectional view when a display unit 105a described later is cut in the cross-section corresponding to the same part as that of FIG. 2.

As illustrated in FIG. 17, a display unit 105a according to the fifth embodiment includes a surface protective layer 8 in place of the shaped sheet 5a in the display unit 104a according to the fourth embodiment. Also in this case, the same operational effects as those of the display device according to the fourth embodiment can be obtained.

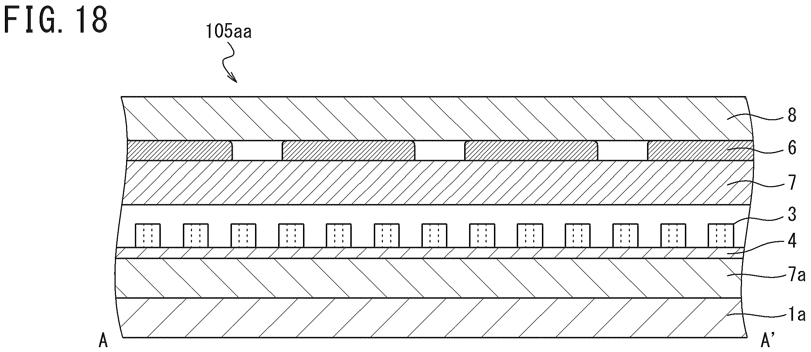

Also in this case, it may be acceptable that the transparent sheet 7a is provided on the front surface of the colored sheet 1a, and the light emitting units 3 and the circuit wiring lines 4 are fixed to the front surface of the transparent sheet 7a as illustrated in the display unit 105aa of FIG. 18 as with the display unit 103aa of FIG. 7. FIG. 18 is a cross-sectional view when the display unit 105aa described later is cut in the cross-section corresponding to the same part as that of FIG. 2.

[Sixth embodiment]

Next, a display device according to a sixth embodiment of the present invention is described.
The display device according to this sixth embodiment specifies the ratio occupied by the light emitting units 3 and the circuit wiring lines 4 in the light-emitting display surface of the display unit in the display device according to each of the first to fifth embodiments. More specifically, when an observer visually observes the light-emitting display surface of the display unit 105a in the display unit 105a of the display device according to the fifth embodiment, for example, the picture pattern printed layer 6, the light emitting units 3, the circuit wiring lines 4, the base material 1, the colored sheet 1a, and the like are included within the field of view of the observer through the surface protective layers 5 and 8, the shaped sheet 5a, or the like. At this time, when the occupied area of the light emitting units 3 or the circuit wiring lines 4 on the colored sheet 1a, for example, increases, the occupied area of the colored sheet 1a relatively decreases in a visually-recognized screen visually recognized by an observer. This reduces the surface area ratio indicating the occupancy ratio of the colored sheet 1a in the visually-recognized screen, so that the color of the colored sheet 1a appears a color different from its actual color in some cases. As a result, in an off state in which the light emitting units 3 are not caused to emit light, the color of the colored sheet 1a is sometimes visually recognized as a different color by the observer in a region where both the colored sheet 1a and the light emitting unit 3 are present and a region where the colored sheet 1a and the light emitting units 3 are not present in the visually-recognized screen. This causes a difference in the appearance in the observer in the region where both the colored sheet 1a and the light emitting unit 3 are present and the region where the colored sheet 1a and the light emitting unit 3 are not present in the off state in which the light emitting units 3 are not caused to emit light. The coexistence of the parts with the different appearance enables the observer to visually recognize the display unit 105a, deteriorating a design harmonious with the space, even though the colored sheet 1a or the picture pattern printed layer 6 is provided to harmonize with the space.
Therefore, in the display unit 105a according to the sixth embodiment, the surface area ratio of the light emitting units 3 and the circuit wiring lines 4 is set to 70% or less, preferably 50% or less, more preferably 30% or less, and still more preferably 20% or less.
Thus, the occupied area of the colored sheet 1a in the visually-recognized screen can be ensured by limiting the surface area ratio of the light emitting units 3 and the circuit wiring lines 4. Therefore, a decrease in the occupied area of the colored sheet 1a in the visually-recognized screen inhibits the coexist state of the colored sheet 1a with different display colors in the visually-recognized screen, making it difficult for the observer to notice the presence of the display unit 101a.

[Seventh embodiment]

Next, a display device according to a seventh embodiment of the present invention is described.
The display device according to this seventh embodiment specifies the size of the light emitting units 3 and the distance between an observer and the light-emitting display surface of the display unit in the display unit in the display device according to each of the first to sixth embodiments. More specifically, when an observer visually observes the light-emitting display surface of the display unit 105a in the display device according to the fifth embodiment, when the size of the light emitting units 3 is large, or when the circuit wiring lines 4 are thick, or the like, for example, the color of the colored sheet 1a is visually recognized as a different color by the observer in a region where the light emitting units 3 or the circuit wiring lines 4 are present on the colored sheet 1a and a region where the light emitting units 3 or the circuit wiring lines 4 are not present as described in the sixth embodiment. Therefore, there is a possibility that the observer can visually recognize the presence of the display unit 105a due to the fact that the visually recognized colors are different, deteriorating a design harmonious with the space.
Therefore, the relationship between a size a of the light emitting unit 3 and an estimated distance between the light-emitting display surface of the display unit 105a and an observer (hereinafter referred to as an estimated distance) A is set such that the relationship represented by Equation (1) below is established. The estimated distance A is acquired by, for example, measuring the distance between a position where the display unit 105a is to be installed and an estimated position of an observer observing the display unit 105a. The size a of the light emitting unit 3 refers to, when the light emitting unit 3 is formed by a 3-in-1 chip LED element, the largest distance between two points on the outer periphery of the chip, refers to, when the light emitting unit 3 is a circular chip, the diameter of the chip, or refers to, when the light emitting unit 3 is a rectangular chip, the length of the diagonal line. When the light emitting unit 3 is formed by three LED elements, the size is the largest distance between two points on the outer periphery of the individual LED element as viewed from the light-emitting surface side.

$$a \leq A/500,$$

preferably

$$a \leq A/1000,$$

more preferably

$$a \leq A/2000,$$

still more preferably

$$a \leq A/5000 \cdots (1).$$

Thus, the size a of the light emitting unit 3 is set to be equal to or less than a threshold (e.g., A/500) according to the estimated distance A. Therefore, in the display device in each of the above-described embodiments, the size a is limited to a relatively small value in an environment where an observer visually observes the light-emitting display surface of the display unit 105a at a position relatively close to the display unit 105a, for example, so that the observer can be inhibited from visually recognizing the display unit 105a. Conversely, the size a is limited to a relatively large value in an environment where an observer visually observes the display unit 105a at a position relatively far from the display unit 105a. Therefore, in an environment where the observer is difficult to visually recognizes the display unit 105a, the number of the light emitting unit 3 can be reduced and options for the LED element as the light emitting unit 3 can be increased by increasing the size a.

In the above-described seventh embodiment, the size a of the light emitting unit 3 is set according to the estimated distance A. The size a of the light emitting unit 3 may be set further considering the vision of an observer.

More specifically, the relationship between the size a of the light emitting unit 3, and the estimated distance A and a vision value n (0 < n) assumed as the vision of an observer is set such that the relationship represented by Equation (2) below is established. θ in Equation (2) refers to the gap of a Landolt ring "C" used in the vision test. θ is represented by Equation (3) below.

$$a = A\sin\theta/n \cdots\cdots (2)$$

$$\theta = (2\pi/360) \times (1/60); \ 1/60 \text{ of } 1° \cdots\cdots (3)$$

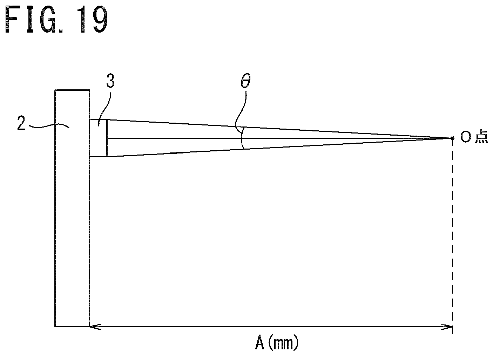

The size a is set to the value of a when Equation (2) is satisfied and the vision value n indicating the vision of 1.0 is 1.0 or less, the n is preferably 1.5 or less, the n is more preferably 2.0 or less, and the n is still more preferably 2.5 or less as illustrated in FIG. 19. More specifically, it is preferable to make it difficult for even those with the vision of 1.0, preferably the vision of 1.5, and more preferably the vision of 2.0 to recognize the presence of the display unit, and it is preferably to make it difficult to recognize the presence of the display unit regardless of whether the vision is good or bad.

Also in this case, in the display device in each of the above-described embodiments, by setting the size a of the light emitting unit 3 further considering the estimated distance A and the vision value n, the size a can be increased in an environment where an observer is difficult to visually recognize the display unit (e.g., 105a), while the observer visually observing the light-emitting display surface of the display unit is being inhibited from recognizing the presence of the display unit.

[Eighth embodiment]

Next, a display device according to an eighth embodiment of the present invention is described.

The display device according to this eighth embodiment specifies wiring lines to be used as the circuit wiring lines 4 in the first to seventh embodiments. More specifically, an observer visually observes the light-emitting display surface of the display unit 105a in the display unit 105a of the display device according to the fifth embodiment, for example, the picture pattern printed layer 6, the light emitting units 3, the circuit wiring lines 4, the base material 1, the colored sheet 1a, and the like are included within the field of view of the observer through the surface protective layers 5 and 8, the shaped sheet 5a, or the like. The light emitting unit 3 contains an inorganic LED element, and the inorganic LED element is driven by a current. Therefore, the circuit wiring lines 4 are thicker than a display device using a liquid crystal display (LCD), for example. When the light emitting units 3 are caused to emit brighter light, a large current is required to be fed, and therefore it is necessary to make the circuit wiring lines 4 thicker. When the circuit wiring lines 4 are made thicker as described above, there is a possibility that an observer can visually recognize the circuit wiring lines 4 in the off state in which the light emitting units 3 are not caused to emit light. Further, when the light emitting units are in the off state, there is a possibility that the appearance of the color of the colored sheet 1a or the like in the observer is different in a region where the light emitting unit 3 and the circuit wiring lines 4 on the colored sheet 1a are present and a region where the light emitting unit 3 and the circuit wiring lines 4 on the colored sheet 1a are not present. The different appearance causes the observer to visually recognize the display unit 105a, deteriorating a design harmonious with the space.

Therefore, the circuit wiring lines 4 are formed using a plurality of thin wiring line in the display device according to the eighth embodiment. Each circuit wiring line 4 of FIG. 1 is illustrated as an example, and a circuit wiring for current is illustrated which is used for the light emission of each inorganic LED element connecting the control unit 101b and the anode side and the cathode side of the inorganic LED element as the light emitting unit 3. Each circuit wiring line 4 is electrically connected to an anode terminal and a cathode terminal of the individual inorganic LED element in the vicinity of the inorganic LED element. The timing of a short or the opening of the circuit containing each inorganic LED element is controlled by the control unit 101b to cause the inorganic LED elements forming the rows to emit light or emit no light, whereby display is performed. When the circuit wiring lines 4 are thick and small in number, there is a possibility that an observer can visually recognize the circuit wiring lines 4 and, when the wiring lines are broken, the current fluctuates, so that the inorganic LED elements cannot be caused to emit light or become dark. On the other hand, when the wiring lines are reduced in thickness and increased in number, the wiring lines are made invisible, so that the design does not deteriorate and, even when some of the plurality of wiring lines are broken, the electrical resistance of the circuit wiring lines hardly changes, and thus the effect on the display while can be can reduced.

Thus, as one wiring line for each of the inorganic LED elements contained in the light emitting units 3 and for feeding a signal or power to the inorganic LED element, i.e., as a wiring line for feeding a signal or power to the inorganic LED element from the control unit 101b, the circuit wiring line 4 connected between the control unit 101b and the inorganic LED elements is formed of a plurality of thin wiring lines.

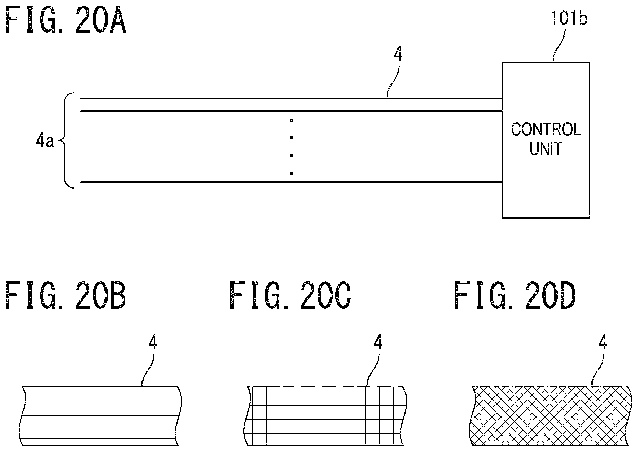

For example, circuit wiring 4a in FIG. 1 includes the plurality of circuit wiring lines 4 connected to the inorganic LED elements contained in the plurality of light emitting units 3 arranged in the same row as illustrated in FIG. 20A. Each of the circuit wiring lines 4 connected to the inorganic LED elements is formed of a plurality of thin wiring lines. For example, the circuit wiring 4a is formed by wiring containing a plurality of parallel wiring lines as illustrated in FIG. 20B, grid wiring in which a plurality of wiring lines is formed in a grid pattern as illustrated in FIG. 20C, or mesh wiring in which a plurality of wiring lines is formed in a mesh pattern as illustrated in FIG. 20D. Thus, by the formation of the circuit wiring lines 4 using the plurality of thin wiring lines, the amount of a current required to drive the light emitting units 3 can be fed, and the wiring lines can be made difficult to be visually recognized by an observer due to the thin wiring lines. Further, the thin wiring lines have possibility of being easily broken, but, even when the breakage occurs, a current can be continuously fed because a certain path is electrically connected due to a shape that the thin wiring lines are connected in places.

[Modification]

The above-described embodiments describe that the light emitting units 3 are arranged on the entire front surface of the base material 1, but the present invention is not limited thereto. For example, the light-emitting display surface may be formed by arranging the light emitting units 3 in a matrix shape only in part of the printed layer 2. More specifically, a decorative sheet, such as wallpaper, may be configured in which the light-emitting display surface is provided only in a part of the decorative sheet.

The above-described embodiments are examples of the present invention, and the present invention is not limited to the above-described embodiments. Even in modes other than the embodiments, various changes can be made according to the design or the like without departing from the technical idea according to the present invention.

Reference Signs List

1                base material

| 1a | colored sheet |
| 1aa | base material |
| 1ab | ink layer |
| 1ac | concealing sheet |
| 1ad | resin layer |
| 2 | printed layer |
| 3 | light emitting unit |
| 4 | circuit wiring line |
| 5 | surface protective layer |
| 5a | shaped sheet |
| 6 | picture pattern printed layer |
| 7 | transparent sheet |
| 8 | surface protective layer |
| 101 | display device |
| 101a to 105a | display unit |
| 101b | control unit |

**Claims**

1. A display device comprising:

   a base material;
   a picture pattern layer formed on a front surface of the base material;
   a plurality of light emitting units fixed to a front surface of the picture pattern layer and each containing an inorganic LED element; and
   a control unit configured to drive the plurality of light emitting units.

2. A display device comprising:

   a base material having light transmittance;
   a picture pattern layer formed on a back surface of the base material;
   a plurality of light emitting units formed on a front surface of the base material and each containing an inorganic LED element; and
   a control unit configured to drive the plurality of light emitting units.

3. The display device according to claim 1 or 2, comprising:
   a surface protective layer provided to cover the plurality of light emitting units and the surface to which the plurality of light emitting units is fixed and having light transmittance.

4. The display device according to claim 3, wherein the surface protective layer contains a light-transmitting shaped sheet formed with a recessed shape or a projection shape in a surface opposite to a side facing the light emitting units of the surface protective layer.

5. A display device comprising:

   a colored sheet;
   a plurality of light emitting units fixed to a front surface of the colored sheet and each containing an inorganic LED element;
   a surface protective layer provided to cover the plurality of light emitting units and the surface to which the plurality of light emitting units is fixed and having light transmittance;
   a pattern forming layer provided on a surface on a side facing the light emitting units of the surface protective layer and configured to impart a pattern to light from the plurality of light emitting units and transmit the light; and
   a control unit configured to drive the light emitting units.

6. The display device according to claim 5, wherein the surface protective layer contains a light-transmitting shaped sheet formed with a recessed shape or a projection shape in a surface opposite to the side facing the light emitting units.

**7.** The display device according to claim 6 comprising:
a transparent sheet having light transmittance between a surface on which the pattern forming layer is provided of the shaped sheet and the light emitting units.

**8.** The display device according to any one of claims 5 to 7, wherein the colored sheet includes: a base material; and an ink layer applied to the base material and configured to lower visibility of an installation surface of the display device and the base material.

**9.** The display device according to claim 8,
wherein

the light emitting units are provided on a front surface of the base material,
circuit wiring lines electrically connecting the light emitting units and the control unit are provided on the front surface of the base material, and
the ink layer has a color lowering visibility of the installation surface of the display device, the base material, and the circuit wiring lines and is formed on the base material and the circuit wiring lines.

**10.** The display device according to any one of claims 5 to 7, wherein

the colored sheet includes: a base material; and a concealing sheet arranged on the base material,
the light emitting units are provided on a front surface of the base material,
circuit wiring lines electrically connecting the light emitting units and the control unit are provided on the front surface of the base material, and
the concealing sheet is a sheet lowering visibility of an installation surface of the display device, the base material, and the circuit wiring lines, has through holes through which the light emitting units pass at positions facing the light emitting units, and is arranged on the circuit wiring lines to make the light emitting units and the through holes face each other.

**11.** The display device according to any one of claims 5 to 7, wherein

the colored sheet includes: a base material; and a concealing sheet arranged on the base material and configured to lower visibility of an installation surface of the display device and the base material,
the light emitting units are provided on a front surface of the base material,
circuit wiring lines electrically connecting the light emitting units and the control unit are provided on the front surface of the base material, and
the concealing sheet is a resin layer formed to cover the base material, the circuit wiring lines, and side surfaces of the light emitting units.

**12.** The display device according to claim 11,
wherein the concealing sheet and the light emitting units are flush with each other.

**13.** The display device according to claim 11,
wherein an upper end of the concealing sheet is lower than an upper end of each of the light emitting units in front view.

**14.** The display device according to claim 11,
wherein an upper end of the concealing sheet is higher than an upper end of each of the light emitting units in front view.

**15.** The display device according to claim 3 comprising:

circuit wiring lines provided on the surface to which the light emitting units are fixed and configured to electrically connect the light emitting units and the control unit, wherein
a surface area ratio is 70% or less, the surface area ratio being a ratio of an area occupied by the light emitting units and the circuit wiring line in the surface to which the light emitting units are fixed.

**16.** The display device according to claim 3 comprising:

circuit wiring lines provided on the surface to which the light emitting units are fixed and configured to electrically connect the light emitting units and the control unit, wherein

one wiring line for each of the inorganic LED elements contained in the light emitting units and for feeding a signal or power to the inorganic LED element is formed of a plurality of thin wiring lines.

**17.** The display device according to claim 3,
wherein the light emitting units are arranged in a matrix shape.

**18.** The display device according to claim 3,
wherein an estimated distance A between the light emitting units and an observer visually recognizing emitted light from the light emitting units and a size a of the light emitting units as viewed from a light-emitting surface side satisfy Equation (1) below,

$$a \leq A/500 \quad \cdots\cdots \quad (1)$$

**19.** The display device according to claim 3,
wherein an assumed vision value n using a Landolt ring of an observer visually recognizing emitted light from the light emitting units satisfies Equation (2) below and is

$$0 < n \leq 1.0,$$

$$a = A\sin\theta/n \quad \cdots\cdots \quad (2)$$

$$\theta = (2\pi/360) \times (1/60)$$

wherein

A is an estimated distance between the light emitting units and the observer visually recognizing the emitted light from the light emitting units, and
a is a size of the light emitting units as viewed from a light-emitting surface side.

**20.** A decorative sheet comprising:

the display device according to claim 3, wherein
the display device is provided on a part of a front surface of the decorative sheet.

**21.** A decorative sheet comprising:

the display device according to claim 5, wherein
the display device is provided on a part of a front surface of the decorative sheet.

**22.** A method for producing a display device,

the display device being the display device according to claim 9,
the method comprising:

forming the circuit wiring lines on the front surface of the base material;
forming an ink layer lowering the visibility of the installation surface of the display device, the base material, and the circuit wiring lines on the front surface of the base material including the circuit wiring lines; and
after forming the ink layer, installing the light emitting units on the front surface of the base material.

FIG. 1

# FIG. 2

101a

A                                    A'

5
3
4
2
1

FIG. 3

FIG. 4

EP 4 354 416 A1

FIG. 5

102aa

5a

3

4

1

2

A                                                                                    A'

FIG. 6

103a

5a
6
3
4
1a

A
A'
T

FIG. 7

EP 4 354 416 A1

## FIG. 8

103a-1

5a

6

3

1a { 1ab
1aa

4

A                                                                                    A'

FIG. 9

EP 4 354 416 A1

FIG. 10

103a-2

A                                                                              A'

5a

6

3

1ac

1a

4

1aa

# FIG. 11

FIG. 12A    FIG. 12B    FIG. 12C

EP 4 354 416 A1

FIG. 13

FIG. 14

EP 4 354 416 A1

FIG. 15

EP 4 354 416 A1

FIG. 16

104aa

5a
6
7
3
4
7a
1a

A                                                                    A'

FIG. 17

105a

8 6 7 3 4 1a

A A'

# FIG. 18

EP 4 354 416 A1

# FIG. 19

A (mm)

FIG. 20A

4

101b

CONTROL
UNIT

4a

FIG. 20B

4

FIG. 20C

4

FIG. 20D

4

# FIG. 21

FIG. 22

## INTERNATIONAL SEARCH REPORT

| International application No. |
| --- |
| **PCT/JP2022/022329** |

### A. CLASSIFICATION OF SUBJECT MATTER

*G09F 13/12*(2006.01)i; *G09F 13/04*(2006.01)i
FI:   G09F13/12; G09F13/04 J; G09F13/04 R

According to International Patent Classification (IPC) or to both national classification and IPC

### B. FIELDS SEARCHED

Minimum documentation searched (classification system followed by classification symbols)

G09F13/12; G09F13/04

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
| --- | --- | --- |
| X | WO 2019/225636 A1 (MITSUBISHI CHEMICAL CORPORATION) 28 November 2019 (2019-11-28) paragraphs [0016]-[0049], [0068]-[0071], [0093], fig. 7, 8 | 5, 8, 9, 21, 22 |
| A | | 1-4, 6, 7, 10-20 |
| A | JP 2005-62441 A (TOWA MECCS CORP) 10 March 2005 (2005-03-10) paragraphs [0032]-[0045], fig. 1-4 | 1-22 |
| A | JP 2020-2594 A (TOPPAN PRINTING CO LTD) 09 January 2020 (2020-01-09) paragraphs [0057]-[0061], fig. 1 | 1-22 |
| A | JP 2016-145482 A (ZNET CORP) 12 August 2016 (2016-08-12) paragraphs [0022]-[0038], fig. 6, 7 | 1-22 |
| A | JP 2013-532848 A (RENSMO, Anders) 19 August 2013 (2013-08-19) paragraphs [0042]-[0054], fig. 1 | 1-22 |
| A | US 2014/0133128 A1 (OH, Nam-Seok) 15 May 2014 (2014-05-15) paragraphs [0052]-[0085], fig. 1A | 1-22 |

☑ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
| --- | --- |
| **29 June 2022** | **19 July 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**

| International application No. |
| --- |
| **PCT/JP2022/022329** |

**C. DOCUMENTS CONSIDERED TO BE RELEVANT**

| Category* | Citation of document, with indication, where appropriate, of the relevant passages | Relevant to claim No. |
| --- | --- | --- |
| A | US 2018/0106462 A1 (SU, Lu) 19 April 2018 (2018-04-19)<br>paragraphs [0021]-[0043], fig. 2, 5, 6 | 1-22 |
| P, X | JP 2021-175995 A (GIKODO CO LTD) 04 November 2021 (2021-11-04)<br>paragraphs [0028]-[0030], fig. 5, 6 | 5-7 |
| P, A | WO 2021/149678 A1 (MITSUBISHI CHEMICAL CORPORATION) 29 July 2021<br>(2021-07-29)<br>paragraphs [0017]-[0060], fig. 3 | 1-22 |

Form PCT/ISA/210 (second sheet) (January 2015)

**INTERNATIONAL SEARCH REPORT**
Information on patent family members

International application No.

**PCT/JP2022/022329**

| Patent document cited in search report | | | Publication date (day/month/year) | Patent family member(s) | | | Publication date (day/month/year) |
|---|---|---|---|---|---|---|---|
| WO | 2019/225636 | A1 | 28 November 2019 | US 2021/0070174 A1 paragraphs [0067]-[0142], [0182]-[0189], [0237]-[0238], fig. 7, 8 | | | |
| | | | | EP | 3799013 | A4 | |
| | | | | CN | 112166467 | A | |
| JP | 2005-62441 | A | 10 March 2005 | (Family: none) | | | |
| JP | 2020-2594 | A | 09 January 2020 | (Family: none) | | | |
| JP | 2016-145482 | A | 12 August 2016 | (Family: none) | | | |
| JP | 2013-532848 | A | 19 August 2013 | US 2013/0120969 A1 paragraphs [0045]-[0058], fig. 1 | | | |
| | | | | EP | 2599077 | A4 | |
| | | | | CN | 103069475 | A | |
| | | | | CA | 2805234 | A1 | |
| US | 2014/0133128 | A1 | 15 May 2014 | KR 10-2014-0061666 | | A | |
| US | 2018/0106462 | A1 | 19 April 2018 | EP | 3529794 | A4 | |
| | | | | CN | 109863548 | A | |
| | | | | CA | 3040501 | A1 | |
| | | | | WO | 2018/075759 | A1 | |
| JP | 2021-175995 | A | 04 November 2021 | (Family: none) | | | |
| WO | 2021/149678 | A1 | 29 July 2021 | (Family: none) | | | |

Form PCT/ISA/210 (patent family annex) (January 2015)

**EP 4 354 416 A1**

REFERENCES CITED IN THE DESCRIPTION

**Patent documents cited in the description**

- JP 2018128581 A
- JP 6370519 B